# EUROPEAN PATENT APPLICATION

(11) **EP 4 586 782 A1**
(43) Date of publication of application: **16.07.2025**
(21) Application number: 24223742.8
(22) Date of filing: 30.12.2024
(51) Int. Cl.: H10K 59/124, H10K 59/131, H10K 59/80

(54) **DISPLAY DEVICE**

(30) Priority: 09.01.2024 KR 20240003493
(71) Applicant: Samsung Display Co., Ltd., Yongin-si, Gyeonggi-do 17113 (KR)
(72) Inventor: KIM, Hwi, Yongin-si (KR); LEE, Joon Gu, Yongin-si (KR); GWARK, Hye Jin, Yongin-si (KR); KIM, Jae Ik, Yongin-si (KR); PARK, Jungsun, Yongin-si (KR); SONG, Seungyong, Yongin-si (KR); LEE, Duck Jung, Yongin-si (KR); LEE, Yeon Hwa, Yongin-si (KR)
(74) Representative: Marks & Clerk LLP

(57) **Abstract**

The display device according to an embodiment includes a substrate comprising a display area and a non-display area, an external common voltage line positioned in the non-display area, a common voltage line positioned in the display area and connected to the external common voltage line, a dam positioned between the substrate and the common voltage line and including an opening, multiple pixels positioned in the display area and including a first electrode and a light emitting layer, and a second electrode positioned above the multiple pixels, the common voltage line is a multi-layer structure including a first layer, a second layer, and a third layer, the first layer includes a planar portion positioned at the opening of the dam and a non-planar portion positioned overlapping the dam.

## Description

### BACKGROUND

### (A) FIELD

This disclosure relates to a display device.

### (B) DESCRIPTION OF THE RELATED ART

A display device is a device that displays images, and recently, light emitting diode displays have recently gained attention as self-luminous display devices.

Light emitting display devices have self-luminous characteristics and, unlike liquid crystal display devices, do not require a separate light source, so thickness and weight can be reduced.

Additionally, light emitting display devices exhibit high-quality characteristics such as low power consumption, high brightness, and high response speed.

Generally, a light emitting display device may include a substrate, a plurality of thin film transistors positioned on the substrate, a plurality of insulating layers disposed between wirings constituting the thin film transistors, and a light emitting element connected to the thin film transistors.

The light emitting device may include a first electrode, a light emitting layer, and a second electrode, and the second electrode may be positioned in a plate shape throughout the display device.

### SUMMARY

Embodiments are intended to provide a display device that improves contact characteristics between electrodes and wiring and prevents voltage drop.

A display device according to an embodiment includes a substrate including a display area and a non-display area, an external common voltage line positioned in the non-display area, a common voltage line positioned in the display area and connected to the external common voltage line, a dam positioned between the substrate and the common voltage line and including an opening, a plurality of pixels positioned in the display area and including a first electrode and a light emitting layer, and a second electrode positioned on the plurality of pixels. The common voltage line has a multi-layer structure including a first layer, a second layer, and a third layer. The first layer includes a planar portion positioned at the opening of the dam and a non-planar portion positioned overlapping the dam.

The second electrode may be in direct contact with a top surface of the first layer and a side surface of the second layer.

The planar portion of the first layer may be positioned closer to the substrate than the non-planar portion.

A thickness of the dam may be 3000 Å to 5000 Å.

The second layer may have a shape that becomes wider toward a center of the second layer.

A width of a widest part of the second layer may be 1.1 to 1.5 times a width of a portion of the second layer where the second layer and the first layer come into contact.

An angle formed between a side surface of the second layer and a top surface of the substrate may be 20 degrees or more and 50 degrees or less.

A thickness of the second layer may be 6000 Å to 10000 Å.

The non-planar portion of the first layer and a side surface of the second layer may be spaced apart from each other.

A spacing area between the non-planar portion of the first layer and the side surface of the second layer may have a length of 200 nm to 300 nm.

The second electrode may be positioned in a spacing area between the non-planar portion of the first layer and the side surface of the second layer.

The third layer may include a planar portion and a non-planar portion, and the planar portion of the third layer may be positioned closer to the substrate than the non-planar portion of the third layer.

The planar portion of the third layer may be in contact with the second layer.

A thickness of the second layer may be greater than a sum of thicknesses of the first layer and the third layer.

A thickness of the second layer may be greater than a thickness of the first layer, and the thickness of the first layer may be greater than a thickness of the third layer.

The first layer may have a thickness of 500 Å to 1000 Å, the second layer may have a thickness of 6000 Å to 10000 Å, and the third layer may have a thickness of 100 Å to 500 Å.

A display device according to an embodiment includes a substrate comprising a display area and a non-display area, an external common voltage line positioned in the non-display area, a common voltage line positioned in the display area and connected to the external common voltage line, a dam positioned between the substrate and the common voltage line and including an opening, a plurality of pixels positioned in the display area and including a first electrode and a light emitting layer, and a second electrode positioned above the plurality of pixels. The common voltage line has a multi-layer structure including a first layer, a second layer, and a third layer. The second electrode directly contacts a top surface of the first layer and a side surface of the second layer.

The first layer may include a planar portion and a non-planar portion, the planar portion of the first layer is positioned closer to the substrate than the non-planar portion, and a spacing area may be positioned between the non-planar portion of the first layer and the side surface of the second layer.

A length of the spacing area may be 200 nm to 300 nm.

A width of a portion of the second layer where the second layer and the first layer come into contact may be narrower than a width of a center of the second layer.

At least some of the above and other features of the invention are set out in the claims.

According to embodiments, a display device is provided that improves contact characteristics of electrodes and wiring, and prevents voltage drop.

### BRIEF DESCRIPTION OF THE DRAWINGS

FIG. 1 briefly shows a display device according to the present embodiment.
FIG. 2 shows a cross-section of a common voltage line according to the present embodiment.
FIG. 3 shows a common voltage line according to a comparative example.
FIGS. 4, 5, 6, and 7 show the manufacturing process of the common voltage line according to the present embodiment.
FIG. 8 briefly shows a cross-section of a pixel of a display device according to the present embodiment.
FIG. 9 is a plan view of a display device according to the present embodiment.
FIGS. 10, 11, 12, 13, 14, 15, 16, 17, and 18 illustrate the display device of FIG. 9 for each layer.

### DETAILED DESCRIPTION OF THE EMBODIMENTS

Hereinafter, with reference to the attached drawings, various embodiments will be described in detail so that those skilled in the art can easily implement the inventive concept.

The inventive concept may be implemented in many different forms and is not limited to the embodiments described herein.

In order to clearly explain the inventive concept, parts that are not relevant to the description are omitted, and identical or similar components are assigned the same reference numerals throughout the specification.

In addition, the size and thickness of each component shown in the drawings are arbitrarily shown for convenience of explanation, so the inventive concept is not necessarily limited to that which is shown.

In the drawings, the thickness is enlarged to clearly express various layers and areas.

In the drawings, for convenience of explanation, the thickness of some layers and regions is exaggerated.

Additionally, when a part of a layer, membrane, region, or plate is said to be "above" or "on" another part, this includes not only cases where it is "directly above" another part, but also cases where there is another part in between.

In contrast, when an element is referred to as being "directly on" another element, there are no intervening elements present.

In addition, being "above" or "on" a reference part means being positioned above or below the reference part, and does not necessarily mean being positioned "above" or "on" it in the direction opposite to gravity.

In addition, throughout the specification, when a part is said to "include" a certain element, this means that it may further include other elements, rather than excluding other elements, unless specifically stated to the contrary.

In addition, throughout the specification, when reference is made to "on a plane," this means when the target portion is viewed from above, and when reference is made to "in cross section," this means when a cross section of the target portion is cut vertically and viewed from the side.

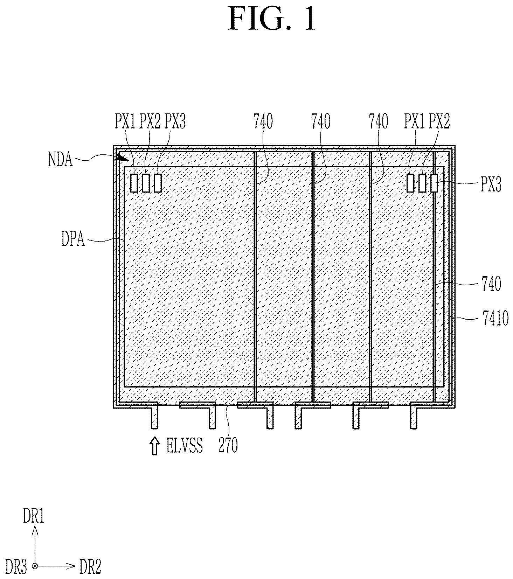

FIG. 1 briefly shows a display device according to an embodiment.

Referring to FIG. 1, the display device according to an embodiment includes a display area DPA and a non-display area NDA.

A plurality of pixels (PX1, PX2, PX3) are positioned in the display area DPA.

For convenience of explanation, in FIG. 1, only some pixels are briefly displayed.

Each pixel PX may include a transistor and a light emitting device connected thereto.

The light emitting device may include a first electrode, a light emitting layer, and a second electrode.

For convenience of explanation, a second electrode 270 is shown in FIG. 1.

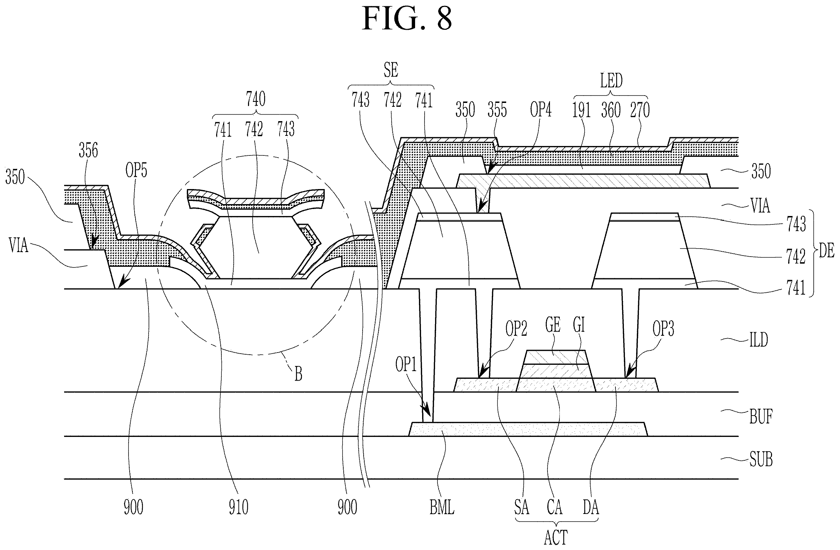

The specific structures of the pixels PX and light emitting elements of the display area will be described separately in FIG. 8 later.

An external common voltage line 7410 is positioned in the non-display area NDA.

The external common voltage line 7410 may be formed to surround the display area DPA.

The external common voltage lines 7410 may be spaced apart from one another and not connected to one side surface of the display area DPA.

The external common voltage line 7410 may transmit a common voltage ELVSS to the second electrode 270 of the pixel PX.

A common voltage line 740 connected to the external common voltage line 7410 is positioned in the display area DPA.

The common voltage line 740 may be positioned along a first direction DR1 and connect the external common voltage lines 7410 to each other.

The common voltage line 740 may be positioned on the same layer as the source and drain electrodes of the display area DPA.

When the external common voltage line 7410 is connected to the common voltage line 740 in this way, the problem of the voltage decreasing during transmission of the common voltage ELVSS can be solved.

That is, when the external common voltage line 7410 is positioned to surround the edge of the display area DPA, a voltage decrease may occur while the common voltage ELVSS is transmitted along the external common voltage line 7410.

However, when the external common voltage line 7410 is connected to the common voltage line 740 positioned in the display area DPA, the voltage transmission path is shortened, thereby preventing a decrease in the common voltage ELVSS.

This common voltage ELVSS is transmitted to the second electrode 270.

Although not shown in FIG. 1, the display device may further include a driving voltage line that transmits a driving voltage.

An external driving voltage line may be positioned in the non-display area NDA, and the driving voltage line positioned in the display area DPA may be connected to the external driving voltage line positioned in the non-display area NDA.

The driving voltage can be delivered to each pixel of the display device through these driving voltage lines.

Referring to FIG. 1, the second electrode 270 may be positioned.

The second electrode 270 may be positioned in both the display area DPA and the non-display area NDA.

The second electrode 270 may receive the common voltage ELVSS by contacting the external common voltage line 7410 in the non-display area NDA.

In FIG. 1, the external common voltage line 7410 and the second electrode 270 may come into contact in the area where they overlap, and the common voltage ELVSS may be transmitted to the second electrode 270.

Additionally, the second electrode 270 may receive the common voltage ELVSS by contacting the common voltage line 740 in the display area DPA.

Since the second electrode 270 may receive the common voltage ELVSS from the display area DPA and the non-display area NDA, voltage drop during the voltage transfer process can be minimized and the common voltage ELVSS can be well transmitted to the second electrode 270.

Although only a portion of the common voltage line 740 is shown in FIG. 1, the common voltage line 740 may be positioned in various numbers depending on the embodiment.

As shown in FIG. 1, the common voltage line 740 and the second electrode 270 may be in contact with only some pixels, or the common voltage line 740 and the second electrode 270 may be in contact with each pixel.

However, because space is required within the display device for the common voltage line 740 and the second electrode 270 to contact each other, the common voltage line 740 and the second electrode 270 can only contact some pixels.

Hereinafter, the structure of the common voltage line 740 positioned in the display area DPA will be described in detail below with reference to the drawings.

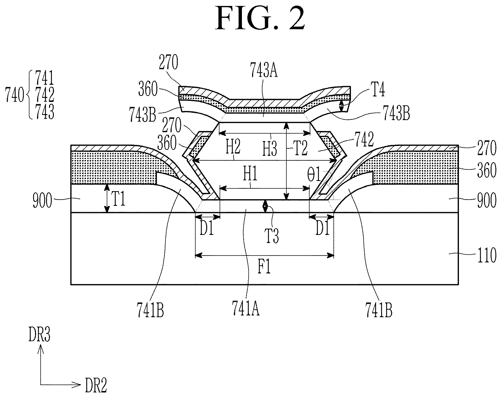

FIG. 2 shows a cross-section of the common voltage line 740 according to this embodiment.

In FIG. 2, for convenience of explanation, only the configuration of a substrate 110, a dam 900, a light emitting layer 360, and a second electrode 270 is shown.

The specific laminated structure will be described later.

As shown in FIG. 2, the common voltage line 740 may have a three-layer structure including a first layer 741, a second layer 742, and a third layer 743.

At this time, as shown in FIG. 2, the second layer 742 may be positioned between the first layer 741 and the third layer 743.

The first layer 741 is positioned along an opening of the dam 900 and a side of the dam 900, and may include a planar portion 741A and a non-planar portion 741B.

The non-planar portion 741B may be positioned at edges of the first layer 741, and the planar portion 741A may be positioned at the center of the first layer 741.

As shown in FIG. 2, the planar portion 741A, sometimes called the flat portion 741A, of the first layer 741 is formed at the opening of the dam 900, and the non-planar portion 741B of the first layer 741 is formed on the dam 900.

Since the dam 900 may have a curved surface, the non-planar portion 741B of the first layer 741 positioned on the dam 900 may also be formed as a curved surface.

That is, the shape of the non-planar portion 741B of the first layer 741 may vary depending on the shape of the side surface of the dam 900.

As shown in FIG. 2, the planar portion 741A of the first layer 741 may be positioned closer to the substrate 110 than the non-planar portion 741B.

In FIG. 2, a thickness T1 in a third direction DR3 of the dam 900 may be 3000 Å to 5000 Å.

The height difference between the planar portion 741A and the non-planar portion 741B of the first layer 741 may also be 3000 Å to 5000 Å.

The third layer 743 may include a planar portion 743A and a non-planar portion 743B.

As shown in FIG. 2, the planar portion 743A may be a portion that is in direct contact with the second layer 742, and the non-planar portion 743B may be a portion that is not in direct contact with the second layer 742.

The planar portion 743A of the third layer 743 may be positioned in the center of the third layer 743, and non-planar portions 743B may be positioned at edges of the third layer 743.

As shown in FIG. 2, the planar portion 743A of the third layer 743 may be positioned closer to the substrate 110 than the non-planar portion 743B.

The second layer 742 may be positioned between the first layer 741 and the third layer 743.

The second layer 742 may have a structure in which the width in a second direction DR2 increases toward the center.

That is, as shown in FIG. 2, a central width H2 may be larger than a lower surface width H1 and an upper surface width H3 of the second layer 742.

At this time, the width H1 of the lower surface and the width H3 of the upper surface may be the same or different.

As shown in FIG. 2, the central width H2 of the second layer 742 may be 1.1 to 1.5 times the width H1 of the lower surface.

If it is less than 1.1 times, a sufficient slope may not be formed, and if it is more than 1.5 times, structural stability may be reduced.

Additionally, as shown in FIG. 2, the second layer 742 may be spaced apart from the first layer 741 in the second direction DR2.

That is, the width H1 of the lower surface of the second layer 742 may be narrower than the width F1 of a flat portion 741A of the first layer 741.

As will be explained later, as the first layer 741 and the second layer 742 are spaced apart, contact between the second electrode 270 and the common voltage line 740 can be made even on the top surface of the first layer 741.

Therefore, the overall contact area increases and stable contact can be implemented.

At this time, the spacing area D1 between the first layer 741 and the second layer 742 may have a length of 200 nm to 300 nm.

As described above, this is the spacing area for contact between the second electrode 270 and the common voltage line 740 even on the top surface of the first layer 741.

If the spacing area D1 has a length less than 200 nm, there may not be enough space for contact between the first layer 741 and the second electrode 270, and if the spacing area D1 has a length more than 300 nm, a light emitting layer 360 is formed without interruption so that the second electrode 270 and the common voltage line 740 do not contact each other.

Additionally, as shown in FIG. 2, the side surface of the second layer 742 may form an inclined surface.

This is because the thickness of the second layer 742 becomes thicker toward the center of the second layer 742 and a slope is formed on the side of the second layer 742.

At this time, an angle Θ1 formed between the side surface of the second layer 742 and the flat portion 741A of the first layer 741 may be 20 degrees or more and 50 degrees or less.

Typically, the angle at which the light emitting layer 360 is deposited is 50 to 60 degrees, so the angle Θ1 formed between the side surface of the second layer 742 and the flat portion 741A of the first layer 741 is 50 degrees or less.

In the case where the angle Θ1 formed by the side of the second layer 742 and the flat portion 741A of the first layer 741 is 50 degrees or less, the light emitting layer 360 is formed to be cut off in that area, and contact between the second electrode 270 and the common voltage line 740 can be made in that area.

However, if the angle Θ1 formed by the flat portion 741A of the first layer 741 is less than 20 degrees, deposition of the second electrode may be difficult, which is not desirable.

In this embodiment, the second layer 742 may be the thickest and the third layer 743 may be the thinnest.

For example, a thickness T3 of the first layer 741 may be 500 Å to 1000 Å.

Additionally, a thickness T4 of the third layer 743 may be 100 Å to 500 Å.

The thickness T2 of the second layer 742 may be 6000 Å to 10000 Å.

The thickness T2 of the second layer 742 may be greater than the sum of the thickness T3 of the first layer 741 and the thickness T4 of the third layer.

If the thickness T3 of the first layer 741 is less than 500 Å, the non-planar portion 741B may not have sufficient durability and may be bent or folded, and if it is more than 1000 Å, the first layer 741 may become thicker, the non-planar portion 741B of layer 741 may not maintain its shape.

Likewise, if the thickness T4 of the third layer 743 is less than 100 Å, the non-planar portion 743A may not have sufficient durability and may be bent or folded, and if it is more than 500 Å, the third layer 743 may become thick, and the non-planar portion 743B of the third layer 743 may not maintain its shape and may be stretched.

Since the third layer 743 is positioned above the first layer 741, the thickness of the third layer 743 is suitably less than that of the first layer 741.

In this embodiment, the thickness T2 of the second layer 742 may be greater than the thickness T1 of the dam.

This is a condition for forming the shape of the common voltage line 740 as shown in FIG. 2 during the manufacturing process, such that the undercut structure and spacing structure may not be formed if the thickness T2 of the second layer 742 is less than the thickness T1 of the dam 900.

That is, if the thickness of the second layer 742 is less than 6000 Å, it may be difficult to form the common voltage line 740 having the shape as shown in FIG. 2, and if the thickness of the second layer 742 is more than 10000 Å, the thickness of the common voltage line 740 may become excessively great, which is undesirable.

In this embodiment, the first layer 741, the second layer 742, and the third layer 743 may each include one or more of Al, Cu, Ti, and alloys thereof.

The second layer 742 may include a material different from the first layer 741 and the third layer 743.

The second layer 742 may include a material that is more easily etched than the first layer 741 and the third layer 743.

The first layer 741 and the third layer 743 may include different materials or the same materials.

For example, the first layer 741 and the third layer 743 may include Ti, and the second layer 742 may include Al.

However, this is only an example, and the inventive concept is not limited thereto.

That is, as shown in FIG. 2, the common voltage line 740 according to this embodiment has a structure in which the first layer 741 and the third layer 743 include planar portions and non-planar portions. In addition, the second layer 742 has a structure in which an undercut is formed with respect to the first layer 741 and the third layer 743, a structure in which the thickness of the second layer 742 increases toward the center, and a structure in which a gap space exists between the second layer 742 and the first layer 741.

Through this structure, the contact area between the common voltage line 740 and the second electrode 270 can be increased to maintain stable contact.

As shown in FIG. 2, the second electrode 270 contacts the upper surface of the first layer 741 of the common voltage line 740 and the spacing area where the first layer 741 and the second layer 742 are spaced apart.

Additionally, contact with the second electrode 270 is made on the side surface of the second layer 742.

At this time, as shown in FIG. 2, based on the thickest part of the second layer 742, contact can be made between the second electrode 270 and the second layer 742 in the lower part of the second layer 742.

As shown in FIG. 2, the light emitting layer 360 is positioned on the side surface of the second layer 742, which is positioned above the thickest part of the central second layer 742, which may result in less contact between the second layer 742 and the second electrode 270.

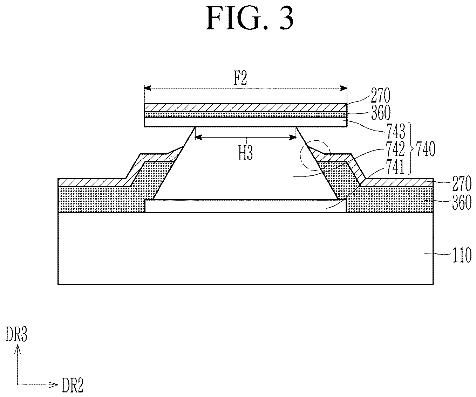

FIG. 3 shows a common voltage line 740 according to a comparative example.

Referring to FIG. 3, the common voltage line 740 according to this comparative example includes a first layer 741, a second layer 742, and a third layer 743.

The comparative example of FIG. 3 has an undercut structure in which the width H3 of the narrowest part of the second layer 742 is less than the width F2 of the third layer 743.

However, the comparative example of FIG. 3 has a somewhat different structure, as it does not include a configuration in which the first layer 741 and the third layer 743 include a planar portion and a non-planar portion as in FIG. 2, a configuration in which the central portion of the second layer 742 protrudes, and a configuration in which a spacing area is positioned between the first layer 741 and the second layer 742.

Referring to FIG. 3, in the comparative example of FIG. 3, the contact area between the common voltage line 740 and the second electrode 270 is very small.

That is, as indicated by a circle in FIG. 3, the second electrode 270 is contacted only on a portion of the side surface of the second layer 742 of the common voltage line 740, and when the contact area is narrow, the contact resistance increases, which is not desirable.

However, in the case of the display device according to the present embodiment, the common voltage line 740 has the shape as shown in FIG. 2, such that the second electrode 270 comes into contact with the upper surface of the first layer 741, the upper surface of the first layer 741, which is positioned in the spacing area between the first layer 741 and the second layer 742, and the side surface of the second layer 742 is expanded.

Therefore, contact resistance can be reduced and stable contact can be achieved.

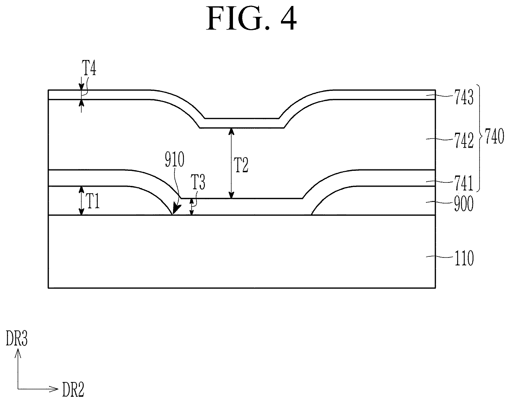

The manufacturing method of the common voltage line 740 according to this embodiment will be described below with reference to FIG. 4 to FIG. 7

FIG. 4 to FIG. 7 show the manufacturing process of the common voltage line according to the embodiment of FIG. 2.

Referring to FIG. 4, a dam 900 is formed on the substrate 110.

For convenience of explanation, FIG. 4 to FIG. 7 show that the dam 900 is directly positioned on the substrate 110, but the embodiment includes a transistor positioned on the substrate 110 and an insulating layer covering the transistor, and the dam 900 can be formed on top of the insulating layer.

The dam 900 may include inorganic material.

For example, the dam 900 may include one or more of SiO₂, SiNx, and SiON.

In other embodiments, the dam 900 may be a complex inorganic material containing organic and inorganic materials.

The thickness T1 of the dam 900 may be 3000 Å to 5000 Å.

As shown in FIG. 4, the dam 900 may include an opening 910.

The side surface of the dam 900 adjacent to the opening 910 may be curved.

The first layer 741, the second layer 742, and the third layer 743 may be formed on the dam 900 and in the opening 910 of the dam 900.

The thickness T3 of the first layer 741 may be 500 Å to 1000 Å.

Additionally, the thickness T4 of the third layer 743 may be 100 Å to 500 Å.

The thickness T2 of the second layer 742 may be 6000 Å to 10000 Å.

The first layer 741, the second layer 742, and the third layer 743 may each include one or more of Al, Cu, Ti, and alloys thereof.

The second layer 742 may include a material different from the first layer 741 and the third layer 743.

For example, the first layer 741 and the third layer 743 may include Ti, and the second layer 742 may include Al.

As shown in FIG. 4, the first layer 741 is positioned above both the dam 900 and the opening 910 of the dam 900.

Accordingly, a step difference is formed in the first layer 741 depending on the height of the dam 900.

As described above, the first layer 741 positioned at the opening 910 of the dam 900 may constitute a planar portion, and the first layer 741 positioned above the dam 900 may constitute a non-planar portion.

Similarly, the third layer 743 also has a step difference due to the level difference between the first and second layers 741 and 742 positioned below, and the third layer 743 includes planar and non-planar portions.

In the first layer 741 and the third layer 743, the non-planar portion may be positioned farther from the substrate than the planar portion.

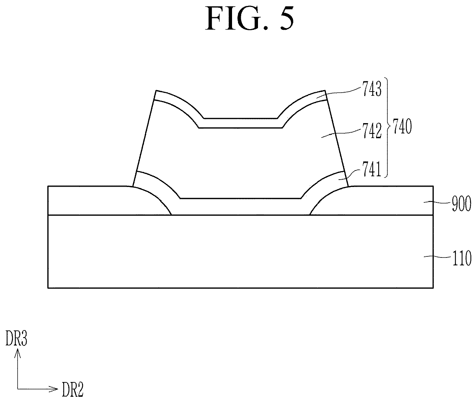

Referring to FIG. 5, the first layer 741, the second layer 742, and the third layer 743 are etched.

The etching at this time may be done by dry etching.

In this etching, the edges of the first layer 741, the second layer 742, and the third layer 743 may be positioned on the same line, wherein the etching of the first layer 741, the second layer 742, and the third layer 743 may be such that the first layer 741 covers the curved side surface of the dam 900.

That is, in this step, the curved side surfaces of the dam 900 may not be exposed during the etching.

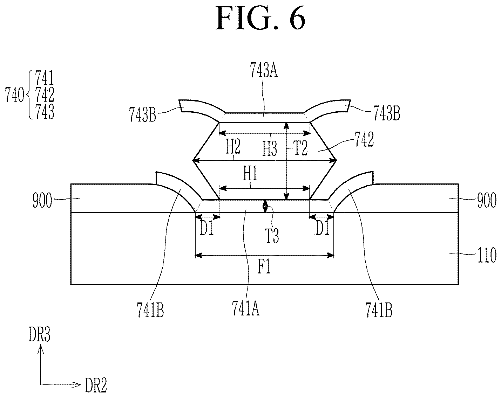

Referring to FIG. 6, the second layer 742 is selectively etched.

That is, in the etching in FIG. 5, the first layer 741, the second layer 742, and the third layer 743 are etched equally, and in the etching in FIG. 6, the second layer 742 is selectively etched.

The etching in this step may be wet etching.

Through this etching, an undercut structure of the second layer 742 and a spacing area between the second layer 742 and the first layer 741 are formed, as shown in FIG. 6.

That is, as shown in FIG. 6, the width H1 of the second layer 742 in the second direction DR2 is narrower than the width F1 of the flat portion 741A of the first layer 741.

Accordingly, a separation area is formed between the second layer 742 and the first layer 741.

Additionally, the central width H2 of the second layer 742 may be larger than the lower surface width H1 and the upper surface width H3.

That is, the second layer 742 may have a structure in which the center portion is widest.

The shape of the second layer 742 formed in the etching process of FIG. 6 can be derived by adjusting the wet etching time.

That is, the shape of the second layer 742 of the common voltage line 740 according to this embodiment can be formed by adjusting the wet etching time without any additional process.

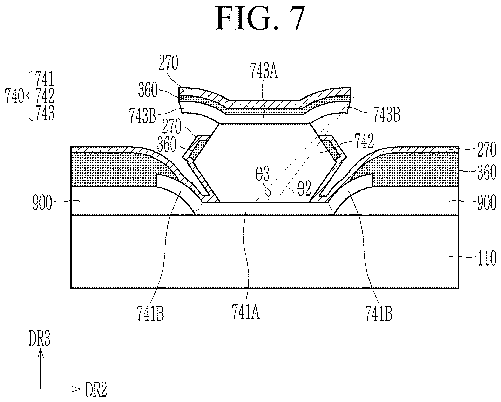

Referring to FIG. 7, the light emitting layer 360 and the second electrode 270 are formed.

At this time, the angle at which the light emitting layer 360 is deposited and the angle at which the second electrode 270 is formed may be different.

As shown in FIG. 7, the angle θ2 at which the light emitting layer 360 is deposited may be different from the angle θ3 at which the second electrode 270 is deposited.

That is, the angle θ3 at which the second electrode 270 is deposited may be smaller than the angle θ2 at which the light emitting layer 360 is deposited.

Therefore, as shown in FIG. 7, the light-emitting layer 360 may not be formed in the space between the first layer 741 and the second layer 742.

Additionally, the light emitting layer 360 may be formed mainly above the thickest central portion of the second layer 742.

The second electrode 270 may be formed at a different angle from the light emitting layer 360, so that the second electrode 270 may be formed in a spacing area between the first layer 741 and the second layer 742.

Therefore, as shown in FIG. 7, the second electrode 270 and the first layer 741 can be in direct contact with the upper surface of the first layer 741.

Additionally, the second electrode 270 is formed on the side of the second layer 742 where the light emitting layer 360 is not formed, so that the second layer 742 and the second electrode 270 can be in direct contact.

Therefore, as shown in FIG. 7, the common voltage line 740 according to this embodiment has a large contact area with the second electrode 270, and can stably establish contact between the second electrode 270 and the common voltage line 740.

Therefore, since the second electrode 270 receives the common voltage from the display area DPA and the non-display area NDA, the voltage drop is minimized during the voltage transfer process and the common voltage is well transmitted to the second electrode 270.

The pixels of the display device including the common voltage line 740 according to this embodiment will be described below.

FIG. 8 briefly shows a cross-section of a pixel of a display device according to this embodiment.

Referring to FIG. 8, this is where a substrate SUB is positioned.

The substrate SUB may include at least one of polystyrene, polyvinyl alcohol, polymethyl methacrylate, polyethersulfone, polyacrylate, polyetherimide, and polyethylene, polyethylene naphthalate, polyethylene terephthalate, polyphenylene sulfide, polyarylate, polyimide, polycarbonate, triacetate cellulose, and cellulose acetate propionate.

The substrate SUB may be a rigid substrate or a flexible substrate capable of bending, folding, rolling, etc.

The substrate SUB may have a single-layer or multi-layer structure.

The substrate SUB may be alternately laminated with at least one base layer containing a sequentially laminated polymer resin and at least one inorganic layer.

A light blocking layer BML may be positioned on the substrate SUB.

The light blocking layer BML may include aluminium (Al), silver (Ag), magnesium (Mg), gold (Au), nickel (Ni), chromium (Cr), calcium (Ca), molybdenum (Mo), and titanium (Ti), tungsten (W), and/or copper (Cu) and metal oxide, and may have a single-layer or multi-layer structure containing these.

A buffer layer BUF may be positioned on the light blocking layer BML.

The buffer layer BUF may include silicon oxide (SiOx), silicon nitride (SiNx), silicon oxynitride (SiOxNy), and amorphous silicon (Si).

The buffer layer BUF may include a first opening OP1 that overlaps and extends to the light blocking layer BML.

A source electrode SE may be connected to the light blocking layer BML at the first opening OP1.

A semiconductor layer ACT may include a channel region CA that overlaps a gate electrode GE, and a source region SA and a drain region DA positioned on both sides of the channel region CA.

A gate insulating layer GI is positioned on the semiconductor layer ACT.

The gate insulating layer GI may include silicon oxide (SiOx), silicon nitride (SiNx), or silicon oxynitride (SiOxNy), and may have a single-layer or multi-layer structure including these.

The gate insulating layer GI may be positioned to overlap the channel area CA of the semiconductor layer ACT.

A gate conductive layer including the gate electrode GE may be positioned on the gate insulating layer GI.

The gate conductive layer may include molybdenum (Mo), aluminium (Al), copper (Cu), titanium (Ti), and metal oxide, and may have a single-layer or multi-layer structure including these.

The gate electrode GE is formed in the same process as the gate insulating layer GI and may have the same planar shape.

However, this is only an example, and the planar shapes of the gate insulating layer GI and the gate electrode GE may be different.

The gate electrode GE may be positioned to overlap the semiconductor layer ACT and the substrate SUB in a direction perpendicular to the surface.

An interlayer insulating layer ILD may be positioned on the semiconductor layer ACT and the gate electrode GE.

The interlayer insulating layer ILD may include silicon oxide (SiOx), silicon nitride (SiNx), and silicon oxynitride (SiOxNy), and may have a single-layer or multi-layer structure including these.

When the interlayer insulating layer ILD has a multilayer structure including silicon nitride and silicon oxide, the layer including silicon nitride may be positioned closer to the substrate SUB than the layer including silicon oxide.

The interlayer insulating layer ILD may have the first opening OP1 extending to and overlapping the light blocking layer BML, a second opening OP2 extending to and overlapping the source area SA of the semiconductor layer ACT, and it may include a third opening OP3 extending to and overlapping the drain area DA.

A data conductive layer including the source electrode SE, a drain electrode DE, and the common voltage line 740 may be positioned on the interlayer insulating layer ILD.

The data conductive layer may be aluminium (Al), silver (Ag), magnesium (Mg), gold (Au), nickel (Ni), chromium (Cr), calcium (Ca), molybdenum (Mo), titanium (Ti), and tungsten (W), and/or copper (Cu) and metal oxide, and may have a single-layer or multi-layer structure including these.

Referring to FIG. 8, the common voltage line 740 may have a three-layer structure including the first layer 741, the second layer 742, and the third layer 743.

The description of each layer of the common voltage line 740 is omitted as it is the same as previously described.

Referring to FIG. 8, a dam 900 is positioned on the interlayer insulating layer ILD.

At this time, the dam 900 may be positioned adjacent to the common voltage line 740.

As shown in FIG. 8, the dam 900 includes an opening 910, and the common voltage line 740 may be positioned in the dam 900 and the opening 910 of the dam 900.

The description of the dam 900 is also omitted as it is the same as previously described.

The source electrode SE may contact the light blocking layer BML at the first opening OP1 and may contact the source area SA of the semiconductor layer ACT at the second opening OP2.

The drain electrode DE may contact the drain area DA of the semiconductor layer ACT at the third opening OP3.

The source electrode SE and the drain electrode DE may be formed through the same process as the common voltage line 740 and may have the same stacked structure.

That is, the source electrode SE and the drain electrode DE may have a three-layer structure including the first layer 741, the second layer 742, and the third layer 743.

However, since the formation of the source electrode SE and the drain electrode DE does not include a selective etching process of the second layer 742 of the common voltage line 740, the first layer 741, the second layer 742, and the third layer 743 of the source electrode SE and drain electrode DE may have the same shape.

An insulating layer VIA may be positioned on the data conductive layer.

The insulating layer VIA may include general-purpose polymers such as polymethylmethacrylate PMMA or polystyrene PS, polymer derivatives with phenolic groups, acrylic polymers, imide polymers, polyimide, siloxane polymers, etc.

The insulating layer VIA may include a fourth opening OP4 extending to and overlapping the source electrode SE and a fifth opening OP5 overlapping the common voltage line 740 and in which the common voltage line 740 is formed.

A first electrode 191 may be positioned on the insulating layer VIA.

A partition 350 may be positioned on the insulating layer VIA and the first electrode 191.

The partition 350 may have an opening 355 that extends to and overlaps the first electrode 191 and an opening 356 that overlaps the fifth opening OP5.

The light emitting layer 360 may be positioned on the first electrode 191 and the partition wall 350.

The second electrode 270 may be positioned on the light emitting layer 360.

The first electrode 191, the light emitting layer 360, and the second electrode 270 may form a light emitting device LED.

As shown by portion B in FIG. 8, the second electrode 270 and the common voltage line 740 come into contact at the fifth opening OP5, and a common voltage is transmitted to the second electrode 270.

The contact form between the second electrode 270 and the common voltage line 740 in portion B is as shown in FIG. 2.

Detailed descriptions of the same components are omitted.

The planar arrangement of the display device according to an embodiment will be described below with reference to the drawings.

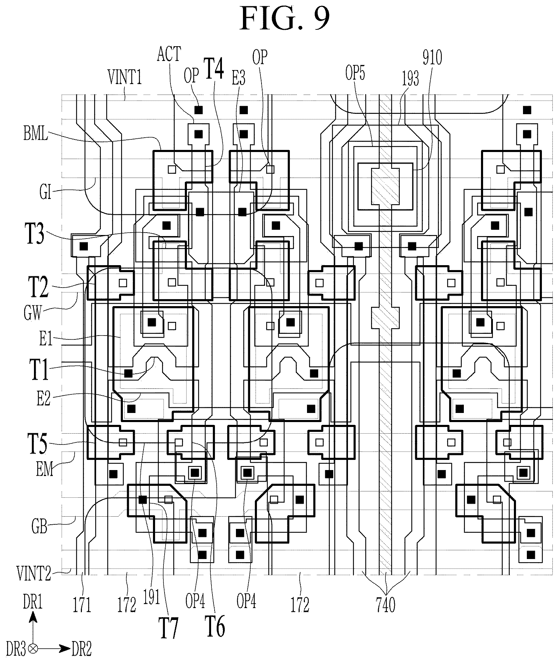

FIG. 9 is a plan view of a display device according to this embodiment.

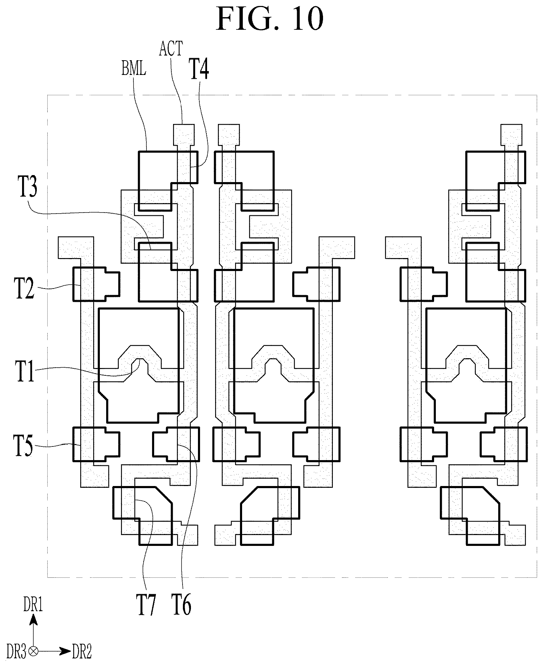

FIGS. 10 to 18 illustrate the display device of FIG. 9 for each layer.

Hereinafter, the planar structure of the display device according to this embodiment will be described with reference to FIG. 9 and FIG. 10 to FIG. 18.

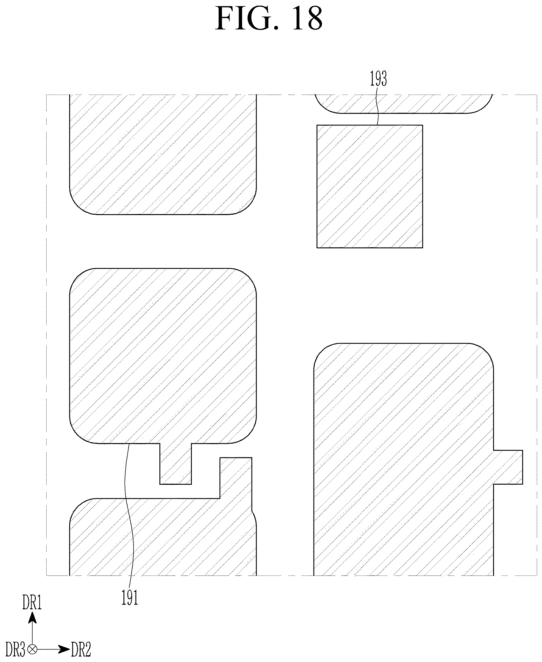

The display device of FIG. 9 shows the configuration of FIG. 10 to FIG. 17, excluding FIG. 18.

Referring to FIG. 9 and FIG. 10, the light blocking layer BML and the semiconductor layer ACT are positioned on the substrate.

As shown in FIG. 10, the semiconductor layer ACT constitutes a plurality of transistors T1, T2, T3, T4, T5, T6, and T7.

Although not shown, a buffer layer may be positioned between the light blocking layer BML and the semiconductor layer ACT.

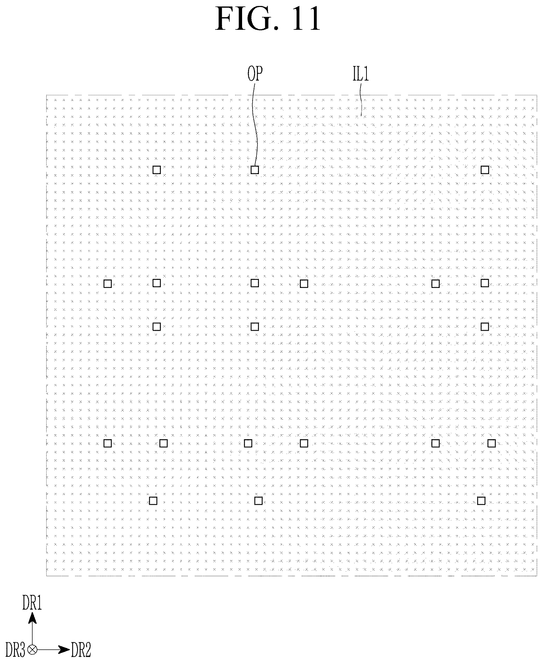

Referring to FIG. 9 and FIG. 11, the first insulating layer IL1 is positioned on the semiconductor layer ACT.

The first insulating layer may include a plurality of openings OP.

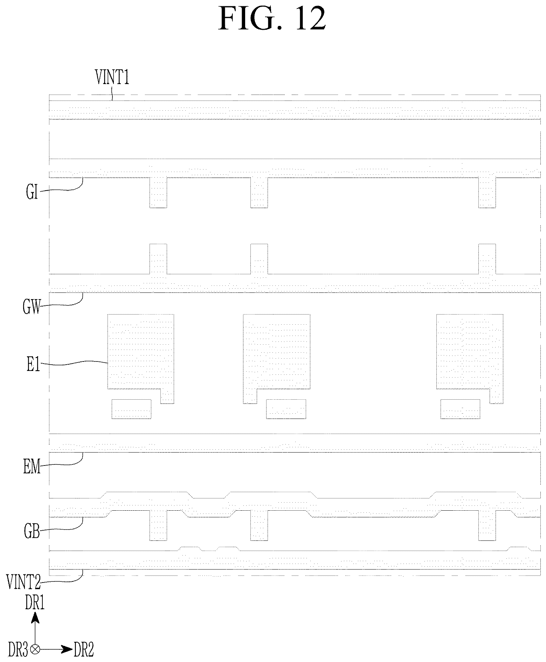

Referring to FIG. 9 and FIG. 12, a first gate conductive layer GAT1 is positioned on the semiconductor layer ACT.

The first gate conductive layer GAT1 may include a plurality of signal lines positioned along the second direction DR2.

Specifically, the first gate conductive layer GAT1 may include a first initialization voltage line VINT1, a first scan line GI, a second scan line GW, an emission control line EM, a bypass control line GB, a second initialization voltage line VINT2, and a first storage electrode E1.

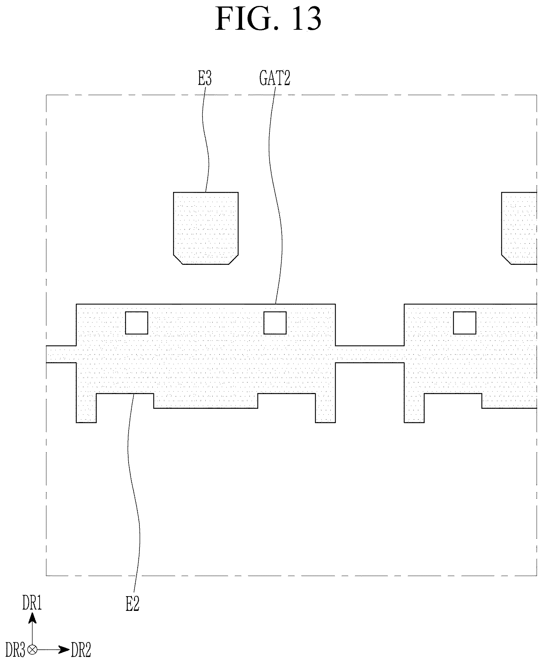

Referring to FIG. 9 and FIG. 13, the second gate conductive layer GAT2 is positioned on the first gate conductive layer GAT1.

Although not shown, a second insulating layer may be positioned between the second gate conductive layer GAT2 on the first gate conductive layer GAT1 to insulate it.

Referring to FIG. 13, the second gate conductive layer GAT2 includes a second storage electrode E2 and a third storage electrode E3.

The second storage electrode E2 may include an opening EOP.

The first storage electrode E1 of the first gate conductive layer GAT1 and the second storage electrode E2 of the second gate conductive layer GAT2 may form a storage capacitor.

Additionally, the third storage electrode E3 of the second gate conductive layer GAT2 may form a capacitor with the first gate conductive layer GAT1.

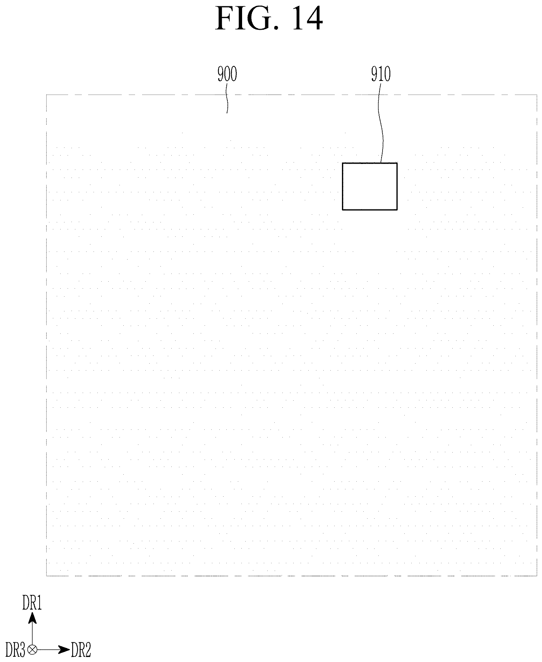

Referring to FIG. 9 and FIG. 14, a dam 900 is positioned on the second gate conductive layer GAT2.

This may have the same configuration as the dam 900 described above.

FIG. 9 and FIG. 14 show a dam 900 and an opening 910 of the dam 900.

That is, the opening 910 of the dam 900 may be formed in an area where the common voltage line 740 and the second electrode 270 come into contact.

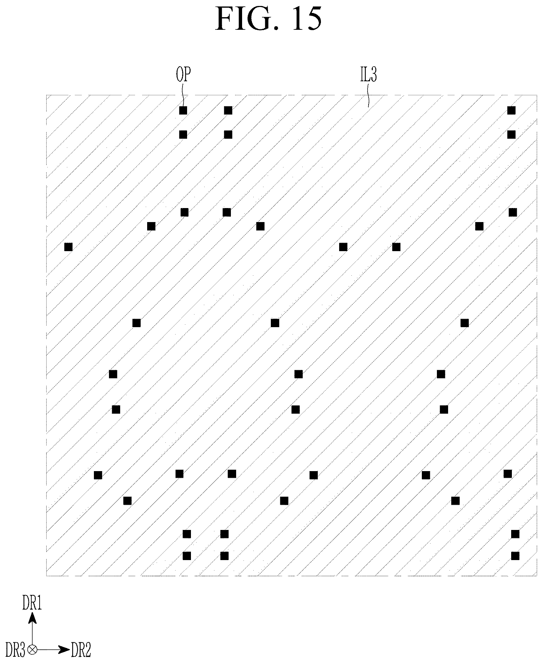

Referring to FIG. 15, a third insulating layer IL3 may be positioned.

The third insulating layer IL3 may include a plurality of openings OP.

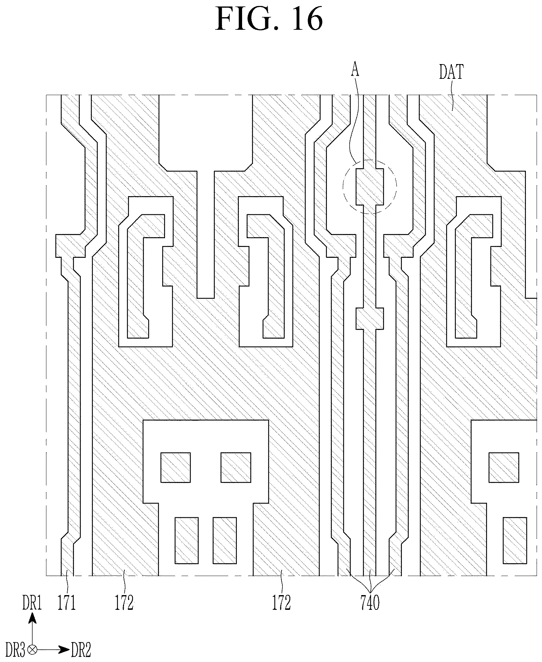

Referring to FIGS. 9 and 16, a data conductive layer DAT is positioned.

The data conductive layer DAT may include a plurality of signal lines positioned along the first direction DR1. Each signal line may include a data line 171, a driving voltage line 172, and the common voltage line 740.

In FIG. 16, the area where contact between the common voltage line 740 and the second electrode 270 occurs -that is, the part where the cross-section of the common voltage line 740 of the inventive concept described above is positioned -is indicated by A.

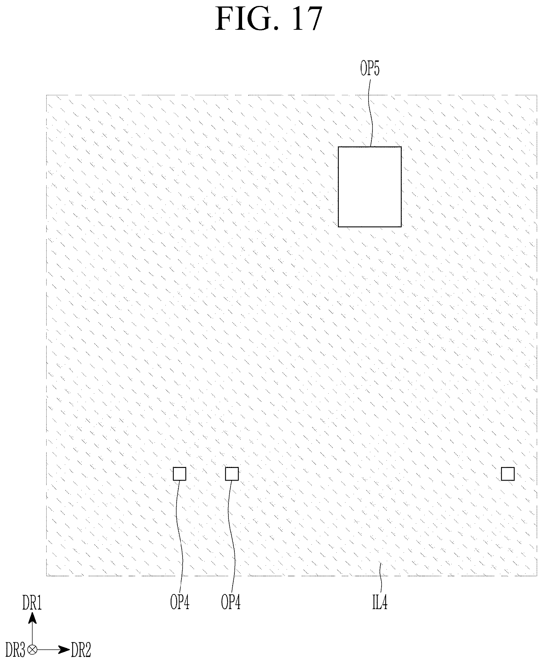

Referring to FIG. 9 and FIG. 17, a fourth insulating layer IL4 may be positioned on the data conductive layer DAT.

The fourth insulating layer IL4 may have a configuration corresponding to the previously described insulating layer VIA.

The fourth insulating layer IL4 may include a plurality of openings.

At this time, the openings may include the fourth opening OP4 and the fifth opening OP5 of the previously described insulating layer VIA.

That is, the fifth opening OP5 is positioned overlapping the common voltage line 740, and subsequently allows the common voltage line 740 and the second electrode 270 to come into contact.

Referring to FIG. 18, the first electrode 191 and an auxiliary electrode 193 are positioned on the fourth insulating layer IL4.

The first electrode 191 may be positioned to correspond to each light emitting device (LED), and the auxiliary electrode 193 may be positioned overlapping the common voltage line 740.

However, the auxiliary electrode 193 may be omitted.

Although not shown hereinafter, a light emitting layer may be positioned on the first electrode 191, and a second electrode may be positioned on the light emitting layer.

The common voltage line 740 and the second electrode may contact the area indicated by A in FIG. 16 as previously described in FIG. 2 to FIG. 8.

However, the above-described planar structure is only an example, and the inventive concept is not limited thereto.

The inventive concept can be applied to various planar pixel arrangements as long as the common voltage line 740 and the second electrode 270 are in contact with each other as shown in FIG. 2.

As described above, the common voltage line 740 according to the present embodiment has a structure in which the first layer 741 and the third layer 743 include planar portions and non-planar portions. The second layer 742 a structure in which an undercut is formed with respect to the third layer 743, a structure in which the thickness of the second layer 742 becomes greater toward the center, and a spacing area exists between the second layer 742 and the first layer 741. Through this structure, the contact area between the common voltage line 740 and the second electrode 270 can be increased, so that the common voltage line 740 and the second electrode 270 can be stably contacted.

Although the embodiments have been described in detail above, the scope of the inventive concept is not limited thereto, and various modifications and improvements can be made by those skilled in the art using the basic concepts of the inventive concept defined in the following claims.

## Claims

1. A display device, comprising:
a substrate including a display area and a non-display area;
an external common voltage line positioned in the non-display area;
a common voltage line positioned in the display area and connected to the external common voltage line;
a dam positioned between the substrate and the common voltage line and including an opening;
a plurality of pixels positioned in the display area and including a first electrode and a light emitting layer, and
a second electrode positioned on the plurality of pixels,
wherein the common voltage line has a multi-layer structure including a first layer, a second layer, and a third layer, and
the first layer includes a planar portion positioned at the opening of the dam and a non-planar portion positioned overlapping the dam.

2. The display device of claim 1, wherein:
the second electrode is in direct contact with a top surface of the first layer and a side surface of the second layer.

3. The display device of claim 1 or claim 2, wherein:
the planar portion of the first layer is positioned closer to the substrate than the non-planar portion.

4. The display device of any one of claims 1 to 3, wherein:
the dam has a thickness of 3000 Å to 5000 Å.

5. The display device of any one of claims 1 to 4, wherein:
the second layer has a shape that becomes wider toward a center of the second layer.

6. The display device of any one of claims 1 to 5, wherein:
a width of a widest part of the second layer is 1.1 to 1.5 times a width of a portion of the second layer where the second layer and the first layer come into contact.

7. The display device of any one of claims 1 to 6, wherein:
(i) an angle between a side surface of the second layer and a top surface of the substrate is 20 degrees or more and 50 degrees or less; and/or
(ii) a thickness of the second layer is 6000 Å to 10000 Å.

8. The display device of any one of claims 1 to 7, wherein:
the non-planar portion of the first layer and a side surface of the second layer are spaced apart from each other.

9. The display device of claim 8, wherein:
(i) a spacing area between the non-planar portion of the first layer and the side surface of the second layer has a length of 200 nm to 300 nm; and/or
(ii) the second electrode is positioned in a spacing area between the non-planar portion of the first layer and the side surface of the second layer.

10. The display device of any one of claims 1 to 9, wherein:
the third layer includes a planar portion and a non-planar portion, and
the planar portion of the third layer is positioned closer to the substrate than the non-planar portion of the third layer, optionally wherein:
the planar portion of the third layer is in contact with the second layer.

11. The display device of any one of claims 1 to 10, wherein:
(i) a thickness of the second layer is greater than a sum of thicknesses of the first layer and the third layer; and/ or
(ii) a thickness of the second layer is greater than a thickness of the first layer, and the thickness of the first layer is greater than a thickness of the third layer.

12. The display device of any one of claims 1 to 11, wherein:
a thickness of the first layer is 500 Å to 1000 Å,
a thickness of the second layer is 6000 Å to 10000 Å, and
the third layer has a thickness of 100 Å to 500 Å.

13. A display device, comprising:
a substrate including a display area and a non-display area;
an external common voltage line positioned in the non-display area;
a common voltage line positioned in the display area and connected to the external common voltage line;
a dam positioned between the substrate and the common voltage line and including an opening;
a plurality of pixels positioned in the display area and including a first electrode and a light emitting layer;
a second electrode positioned on the plurality of pixels,
wherein the common voltage line has a multi-layer structure including a first layer, a second layer, and a third layer, and
the second electrode is in direct contact with a top surface of the first layer and a side surface of the second layer.

14. The display device of claim 13, wherein:
the first layer includes a planar portion and a non-planar portion,
the planar portion of the first layer is positioned closer to the substrate than the non-planar portion, and
a spacing area is positioned between the non-planar portion of the first layer and the side surface of the second layer, optionally wherein:
a length of the spacing area is 200 nm to 300 nm.

15. The display device of claim 13 or claim 14, wherein:
a width of a portion of the second layer where the second layer and the first layer contact each other is narrower than a width of a center of the second layer.
